# EUROPÄISCHE PATENTSCHRIFT

(11) **EP 0 465 721 B1**
(45) Veröffentlichungstag und Bekanntmachung des Hinweises auf die Patenterteilung: **14.06.1995**
(21) Anmeldenummer: 90123413.8
(22) Anmeldetag: 06.12.1990
(51) Int. Cl.: B22D 27/04, C30B 11/00, F27D 1/00

(54) **Schmelz- und Giessofen**
Melting and pouring furnace
Four de fusion et coulée

(30) Priorität: 13.07.1990 DE 4022389
(43) Veröffentlichungstag der Anmeldung: 15.01.1992
(73) Patentinhaber: LEYBOLD AKTIENGESELLSCHAFT, D-63450 Hanau (DE)
(72) Erfinder: Mosch, Johannes, Dipl.-Ing., W-8755 Alzenau 2 (DE)
(74) Vertreter: Sartorius, Peter, Dipl.-Ing.

(56) Entgegenhaltungen:
- EP-A- 0 289 393
- GB-A- 2 017 549
- US-A- 3 342 559
- US-A- 3 953 174
- PATENT ABSTRACTS OF JAPAN vol. 8, no. 212 (C-244)(1649) 27. September 1984

## Beschreibung

Die Erfindung bezieht sich auf einen Schmelz- und Gießofen zur Herstellung von gerichtet erstarrten oder einkristallinen Strukturen mit einer in einem Gehäuse vorgesehenen Heizvorrichtung und einem darunter angeordneten Kühlring sowie einem Kühltisch zum Aufsetzen einer Gießform, wobei im Bereich einer ersten Heizzone zwischen der Gießform und dem Kühlring eine Blende vorgesehen ist, die die Heizzone von der Kühlzone trennt.

Es ist bereits ein Vakuum-, Induktions-, Schmelz- und Gießofen für das Herstellen von gerichtet erstarrten oder einkristallinen Strukturen bekannt (Leybolddruckschrift Vakuum- Präzisions- Gießtechnik, Druckvermerk 32-100.01), der mit einer Heiz- und Kühleinrichtung ausgestattet ist. Die Heiz- und Kühleinrichtung besteht aus einem Zweizonen-Heizer, mit dem eine gezielte Energiezufuhr für das zu schmelzende Gut vorgenommen werden kann. Für die Produktion von gerichtet erstarrten oder einkristallinen Strukturen ist es erforderlich, einen steilen Temperaturgradienten in einem axialen Wärmestrom senkrecht zur flüssig-fest Grenzfläche des Gußstücks zu erzielen. Dafür wird die Form auf eine Kühlplatte aufgesetzt und vor dem Abguß auf Temperaturen über dem Schmelzpunkt der zu vergießenden Legierung aufgeheizt. Eine mit hoher Präzision arbeitende Abzugsanlage führt die mit der Schmelze gefüllte Form mit einer programmierten Geschwindigkeit aus der Heizeinrichtung heraus.

Demgegenüber liegt der Erfindung die Aufgabe zugrunde, die Heiz- und Kühleinrichtung derart auszubilden und anzuordnen, daß sich der Temperaturgradient in der Zone zwischen Liquidus und Solidus vergrößert. Gelöst wird die Aufgabe erfindungsgemäß dadurch, daß in der Heizzone mehrere untereinander angeordnete Strahlungsblenden vorgesehen sind, die mit Abstand zueinander angeordnet sind und die Wärmestrahlen von der Kühlzone abschatten. Bei der Verwendung der einzelnen Strahlungsblenden wird eine Streustrahlung verhindert, so daß sich im Bereich der Zone zwischen Liquidus und Solidus ein steiler Temperaturgradient einstellen kann. Durch die Abschattung der Streustrahlen wird eine direkte Einstrahlung auf den Formteil mit dem bereits erstarrten oder in der Erstarrung befindlichen Guß verhindert. Durch das sehr große Temperaturgefälle in der Zone zwischen Solidus und Liquidus wird der Erstarrungsprozeß vorteilhaft beeinflußt und dadurch die Mikroporösität des erstarrten Gußteils wesentlich verbessert.

Gemäß einem besonderen Merkmal der erfindungsgemäßen Lösung ist schließlich vorgesehen, daß die Strahlungsblenden senkrecht zur Längsmittelachse der Gießform angeordnet sind, so daß die Wärmestrahlung direkt auf die Gießform auftrifft und Streustrahlung vermieden wird.

Eine andere Weiterbildung der erfindungsgemäßen Vorrichtung besteht darin, daß die einzelnen Strahlungsblenden mit ihrer jeweiligen Innenkante mit Abstand zur Außenwand der Gießform angeordnet sind, und daß die einzelnen Strahlungsblenden senkrecht zur Längsmittelachse der Gießform angeordnet sind. Auf diese Weise wird sichergestellt, daß nur ein kleines Strahlenbündel auf eine ganz bestimmte Stelle an der Übergangsstelle zwischen den beiden Zonen auf die Gießform auftrifft. Das Temperaturgefälle zwischen den beiden Zonen kann somit auf einfache Weise erhöht werden. Durch den neu gebildeten Ringspalt wird der Strahlengang stark eingeschnürt und dadurch einer Verflachung des Temperaturgradienten entgegengewirkt.

Zweckmäßig weisen die einzelnen Strahlungsblenden einen gleichmäßigen Abstand untereinander auf. Von besonderer Bedeutung ist bei der erfindungsgemäßen Vorrichtung, daß die einzelnen Strahlungsblenden als Ringblenden ausgebildet sind, die koaxial zur Längsmittelachse der Gießform angeordnet sind. Vorteilhaft ist es ferner, daß die einzelnen Strahlungsblenden als Ringblenden ausgebildet sind und unterschiedlich große Durchmesser aufweisen. Ferner ist es möglich, daß die Strahlungsblenden gleich große Durchmesser aufweisen.

Gemäß eines besonderen Merkmals der erfindungsgemäßen Lösung ist schließlich vorgesehen, daß die unterste Strahlungsblende im Bereich des wassergekühlten Kühlrings angeordnet bzw. auf diesem befestigt ist. Um den Einbau der Strahlungsblenden zu verbessern, ist es gemäß der Erfindung vorteilhaft, daß die Strahlungsblenden in einem Rahmen befestigt und innerhalb der Heizungsvorrichtung einbaubar und austauschbar sind.

Weitere Merkmale der Erfindung sind in der Beschreibung der Figuren dargestellt, wobei bemerkt wird, daß alle Einzelmerkmale und alle Kombinationen von Einzelmerkmalen erfindungswesentlich sind.

In den Figuren sind der Stand der Technik und die Erfindung gegenübergestellt. Es zeigen:
- Figur 1: eine Seitenansicht eines bekannten Schmelz- und Gießofens mit einer Strahlungsblende,
- Figur 2: eine Seitenansicht eines Ausführungsbeispiels eines erfindungsgemäßen Schmelz- und Gießofens mit zahlreichen untereinander angeordneten Strahlungsblenden.

In der Zeichnung ist mit 1 ein Schmelz- und Gießofen bezeichnet, der zur Herstellung von gerichtet erstarrten oder einkristallinen Strukturen dient. Der Schmelz- und Gießofen 1 besteht aus einem in der Zeichnung nur teilweise dargestellten Gehäuse 2 aus wärmeisolierendem Material, dessen Oberseite mit einem Deckel 18 verschlossen ist.

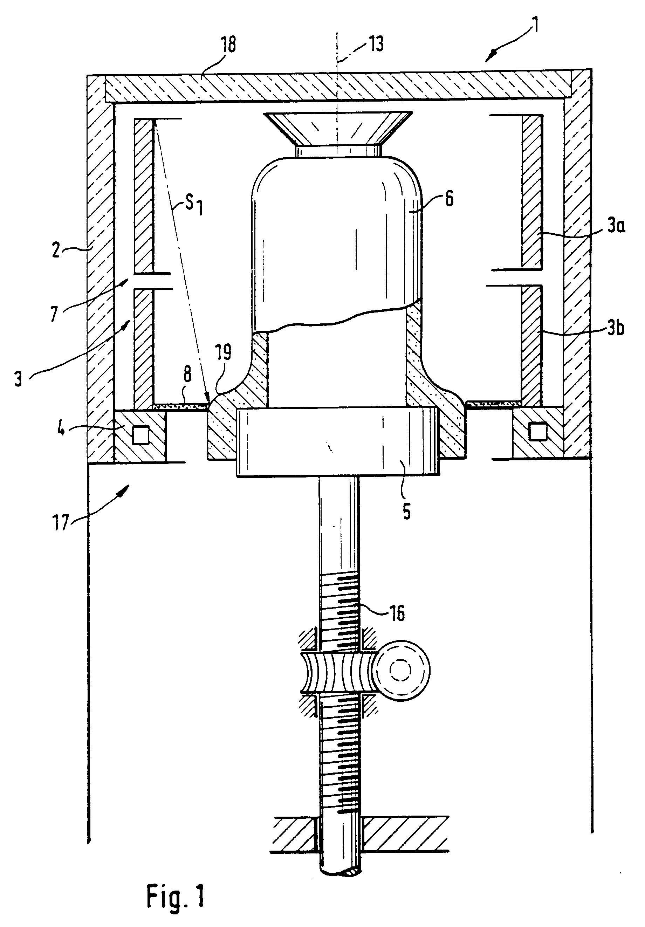

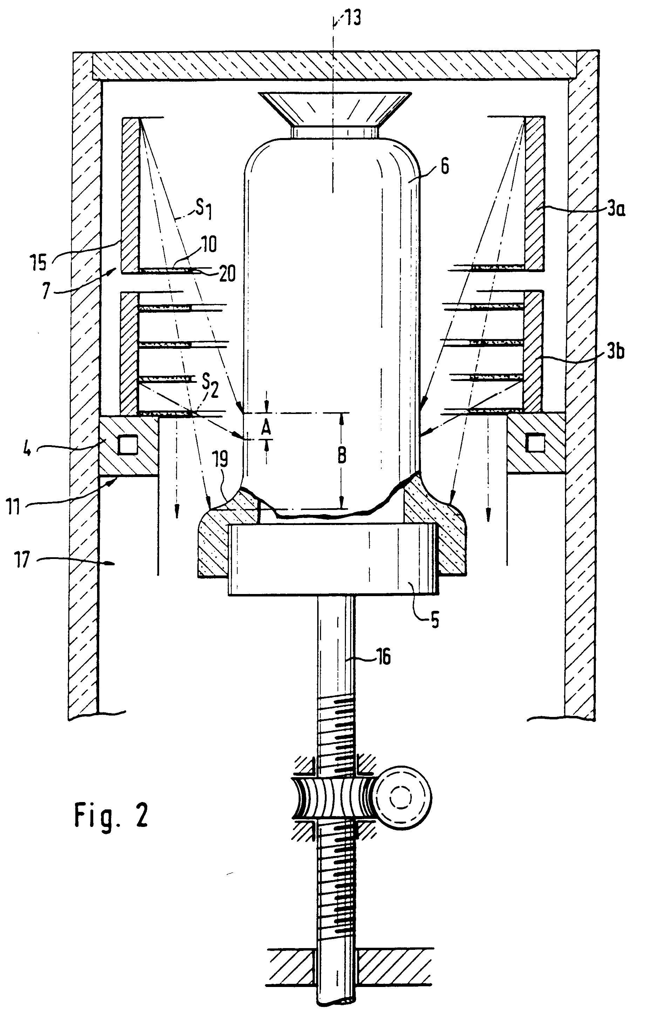

Innerhalb des Gehäuses 2 ist eine Heiz- und Kühlvorrichtung 3 vorgesehen, zu der mehrere Widerstandsheizelemente 3a und 3b gehören. Die Widerstandsheizelemente 3a und 3b sind ringförmig in dem Gehäuse angeordnet und umgeben eine Gießform 6. Die Heizeinrichtung 3 ist als Zwei-Zonen-Heizeinrichtung ausgebildet. Im Ausführungsbeispiel gemäß Figur 1 ist eine bekannte Anordnung eines Schmelz- und Tiegelofens 1 dargestellt, der mit nur einer Strahlungsblende 8 ausgerüstet ist, während im Ausführungsbeispiel gemäß Figur 2 zahlreiche Strahlungsblenden 10 vorgesehen sind. Auf die Unterschiede wird nachstehend noch eingegangen.

Die Gießform 6 ist auf einen Kühltisch 5 abgestellt. Dieser ist auf einer in der Zeichnung nur schematisch angedeuteten Hubvorrichtung 16 angeordnet, mittels der der Kühltisch 5 mit der darauf abgestellten Gießform 6 zwischen einer oberen Stellung und einer unteren Stellung verstellbar ist.

Die obere Heizzone 7 und die untere Kühlzone 17 sind gemäß Figur 1 durch eine Strahlungsblende 8 voneinander getrennt. An der in ausgezogenen Linien dargestellten Gießform 6 läßt sich erkennen, daß die Strahlungsblende 8 bis an die Außenseite der Gießform heranreicht, so daß keine Wärmestrahlen von der oberen Heizzone 7 in die untere Kühlzone 17 gelangen.

Gemäß der Figuren 1 und 2 befindet sich die Hubvorrichtung 16 zur Aufnahme eines Kühltischs 5 in einer oberen Stellung. In dieser Stellung ist der Kühltisch 5 mit der aufgesetzten Gießform 6 einwandfrei abgedichtet. In der oberen Heizzone 7 wird Gußmaterial mit dem Heizer 3a lediglich flüssig gehalten. Wird nun der Kühltisch 5 mit der Gießform 6 während des Erstarrungsprozesses allmählich abgesenkt, so bildet sich zuerst zwischen der Strahlungsblende 8 und der Gießform 6 ein Ringspalt, da sich die untere Erweiterung 19 der Gießform 6 beim Absenkvorgang von der Strahlungsblende wegbewegt. Damit aber dem schon erstarrten Material in der Solidus-Zone keine Wärmeenergie in konzentrierter Form zugeführt wird, sind erfindungsgemäß zahlreiche ringförmige Strahlungsblenden 10 senkrecht zur Längsmittelachse 13 der Gießform 6 angeordnet. Die Strahlungsblenden 10 sind mit einem Abstand zur Außenseite der Gießform 6 angeordnet und bilden auf diese Weise mit ihrer Innenkante 20 einen Ringspalt über die gesamte Länge der Gießform 6. In vorteilhafter Weise sind die einzelnen Strahlungsblenden 10 rechtwinklig zur Längsmittelachse 13 der Gießform 6 angeordnet. Sie können untereinander einen gleichmäßigen Abstand aufweisen.

Wie aus Figur 1 hervorgeht, verläuft der Strahlengang S₁ bis in den unteren Bereich der Gießform 6 und trifft dabei auf die Erweiterung 19. Für die Produktion von gerichtet erstarrten oder einkristallinen Strukturen ist es erforderlich, einen hohen Temperaturgradienten und einen axialen Wärmestrom senkrecht zur flüssigfest Grenzfläche zu erzielen. Dafür wird die Gießform auf den Kühltisch 5 abgestellt und vor dem Abguß auf Temperaturen über dem Schmelzpunkt der zu vergießenden Legierung aufgeheizt. Eine mit hoher Präzision arbeitende Abzugsanlage, die in der Zeichnung nicht dargestellt ist, führt die mit der Schmelze gefüllte Gießform 6 mit einer programmierten Geschwindigkeit aus der Heizvorrichtung heraus. Um den beim Absenkungsvorgang zwischen Strahlungsblende 10 und Gießform 6 sich normalerweise bildenden Ringspalt klein zu halten, sind gemäß Figur 2 zahlreiche Strahlungsblenden 10 untereinander vorgesehen. Aus dem Strahlenverlauf S₁ und S₂ gemäß Figur 2 geht hervor, daß die Wärmestrahlen nur in einem kleinen Bereich A auf die Außenseite der Gießform 6 auftreffen. Wären die Strahlungsblenden 10 nicht vorhanden, so würde ein wesentlich größerer Bereich B mittels der Heizung aufgeheizt. Durch Vermeidung der direkten Einstrahlung (Bereich B) auf die Gießform 6 gemäß Figur 2 mit dem bereits erstarrten oder in der Erstarrung befindlichen Guß, wird das Temperaturgefälle zwischen der Solidus- und Liquiduszone stark vergrößert und damit zwangsläufig der Temperaturgradient steiler.

Im Ausführungsbeispiel sind lediglich vier Strahlungsblenden 10 untereinander angeordnet. Je nach Ausbildung, Höhe und Breite können weitere Strahlungsblenden 10 vorgesehen werden. So ist es denkbar, über die gesamte Länge der Gießform 6 bzw. des Gehäuses 2 Strahlungsblenden 10 vorzusehen. Die Strahlungsblenden 10 sind in vorteilhafter Weise in einem in der Zeichnung nicht dargestellten Gestell gemeinsam aufgenommen und können zwischen Heizvorrichtung 3 und Gießform 6 eingesetzt werden. Es ist ferner möglich, die als Ringe ausgebildeten Strahlungsblenden 10 mit unterschiedlich großen Innendurchmessern zu versehen. Die unterste Strahlungsblende 10 ist auf einem Kühlring 4 angeordnet. Dieser ist im Bereich der beiden Zonen Liquidus und Solidus vorgesehen.

Mit der erfindungsgemäßen Anordnung kann ein gerichtet erstarrtes Gußstück höherer Qualität und geringerer Mikroporösität erzielt werden, da der negative Einfluß der Streustrahlung in dem Solidusbereich vermindert wird.

## Patentansprüche

1. Schmelz- und Gießofen (1) zur Herstellung von gerichtet erstarrten oder einkristallinen Strukturen mit in einem Gehäuse (2) vorgesehener Heizvorrichtung (3) und einem darunter angeordneten Kühlring (4) sowie einem Kühltisch (5) zum Aufsetzen einer Gießform (6), wobei im Bereich einer Heizzone (7) zwischen der Gießform (6) und dem Kühlring (4) eine Blende (8) vorgesehen ist, die die Heizzone (7) von der Kühlzone (11) trennt, **dadurch gekennzeichnet**, daß in der Heizzone (7) mehrere untereinander angeordnete Strahlungsblenden (10) vorgesehen sind, die mit Abstand zueinander angeordnet sind und die Streustrahlung in die Kühlzone (11) vermindern.

2. Schmelz- und Gießofen nach Anspruch 1, **dadurch gekennzeichnet**, daß die Strahlungsblenden (10) senkrecht zur Längsmittelachse (13) der Gießform (6) angeordnet sind.

3. Schmelz- und Gießofen nach Anspruch 1, **dadurch gekennzeichnet**, daß die einzelnen Strahlungsblenden (10) mit ihrer jeweiligen Innenkante (20) mit Abstand zur Außenwand der Gießform (6) angeordnet sind.

4. Schmelz- und Gießofen nach einem oder mehreren der vorhergehenden Ansprüche, **dadurch gekennzeichnet**, daß die einzelnen Strahlungsblenden (10) senkrecht zur Längsmittelachse der Gießform (6) angeordnet sind.

5. Schmelz- und Gießofen nach einem oder mehreren der Vorhergehenden Ansprüche, **dadurch gekennzeichnet**, daß die einzelnen Strahlungsblenden (10) einen gleichmäßigen Abstand untereinander aufweisen.

6. Schmelz- und Gießofen nach einem oder mehreren der vorhergehenden Ansprüche, **dadurch gekennzeichnet**, daß die einzelnen Strahlungsblenden (10) als Ringblenden ausgebildet sind, die koaxial zur Längsmittelachse (13) der Gießform (6) angeordnet sind.

7. Schmelz- und Gießofen nach einem oder mehreren der vorhergehenden Ansprüche, **dadurch gekennzeichnet**, daß die einzelnen Strahlungsblenden (10) als Ringblenden ausgebildet sind und jeweils den gleichen Innendurchmesser aufweisen.

8. Schmelz- und Gießofen nach einem oder mehreren der Vorhergehenden Ansprüche, **dadurch gekennzeichnet**, daß die einzelnen Strahlungsblenden (10) als Ringblenden ausgebildet sind und unterschiedlich große Durchmesser aufweisen.

9. Schmelz- und Gießofen nach einem oder mehreren der vorhergehenden Ansprüche, **dadurch gekennzeichnet**, daß die unterste Strahlungsblende (10) im Bereich des Kühlrings (4) angeordnet bzw. auf diesem befestigt ist.

10. Schmelz- und Gießofen nach einem oder mehreren der vorhergehenden Ansprüche, **dadurch gekennzeichnet**, daß die Strahlungsblenden (10) in einem Rahmen befestigt und innerhalb der Heizungsvorrichtung (15) einsetzbar sind.

## Claims

1. Melting and casting furnace (1) for the production of directionally solidified or mono-crystalline structures, having a heating apparatus (3) provided in a housing (2) and a cooling ring (4) disposed beneath it, as well as a cooling table (5) for holding a mold (6), a shield (8) being provided in the area of a heating zone (7) between the mold (6) and the cooling ring (4) and separating the heating zone (7) from the cooling zone (11), characterized in that, in the heating zone (7), a plurality of radiation shields (10) arrayed together are provided, which are arranged at a distance apart from one another and which shade the heat rays away from the cooling zone (11).

2. Melting and casting furnace according to Claim 1, characterized in that the radiation shields (10) are arranged perpendicularly to the longitudinal central axis (13) of the mold (6).

3. Melting and casting furnace according to Claim 1, characterized in that the individual radiation shields (10) are arranged with their inner edge (20) at a distance from the outer wall of the mold.

4. Melting and casting furnace according to one or more of the preceding claims, characterized in that the individual radiation shields (10) are arranged perpendicular to the longitudinal central axis of the mold (6).

5. Melting and casting furnace according to one or more of the preceding claims, characterized in that the individual radiation shields (10) have a uniform distance apart from one another.

6. Melting and casting furnace according to one or more of the preceding claims, characterized in that the individual radiation shields (10) are configured as ring shields which are arranged coaxially with the longitudinal central axis (13) of the mold (6).

7. Melting and casting furnace according to one or more of the preceding claims, characterized in that the individual radiation shields (10) are configured as ring shields and each have equal inner diameters.

8. Melting and casting furnace according to one or more of the preceding claims, characterized in that the individual radiation shields (10) are configured as ring shields and each have different diameters.

9. Melting and casting furnace according to one or more of the preceding claims, characterized in that the lowermost radiation shield (10) is disposed in the area of the water-cooled cooling ring (4) or fastened thereon.

10. Melting and casting furnace according to one or more of the preceding claims, characterized in that the radiation shields (10) are fastened in a frame and can be installed within the heating apparatus (15).

## Revendications

1. Four de fusion et de coulée (1) pour la réalisation de structures à solidification dirigée ou monocristallines comportant un dispositif de chauffage (3) prévu dans un boîtier (2) et un anneau de refroidissement (4) disposé au-dessous, ainsi qu'une table de refroidissement (5) pour déposer un moule (6), et dans lequel un écran (8) est prévu dans une zone de chauffe (7) entre le moule (6) et l'anneau de refroidissement (4) qui sépare la zone de chauffe (7) de la zone de refroidissement (11), **caractérisé en ce que** plusieurs écrans de protection contre le rayonnement (10) disposés les uns au-dessous des autres et ayant un écart les uns par rapport aux autres sont prévus dans la zone de chauffe (7) qui ont pour effet de réduire le rayonnement diffus dans la zone de refroidissement (11).

2. Four de fusion et de coulée suivant la revendication 1, **caractérisé en ce que** les écrans de protection contre le rayonnement (10) sont disposés verticalement par rapport à l'axe médian longitudinal (13) du moule (6).

3. Four de fusion et de coulée suivant la revendication 1, **caractérisé en ce qu**'un écart subsiste entre le bord intérieur (20) de chacun des écrans de protection contre le rayonnement (10) et la paroi extérieure du moule (6).

4. Four de fusion et de coulée selon l'une quelconque ou plusieurs des revendications ci-avant, **caractérisé en ce que** les écrans de protection contre le rayonnement (10) sont disposés verticalement par rapport à l'axe médian longitudinal du moule (6).

5. Four de fusion et de coulée selon l'une quelconque ou plusieurs des revendications ci-avant, **caractérisé en ce que** les écrans de protection contre le rayonnement (10) sont équidistants les uns des autres.

6. Four de fusion et de coulée selon l'une quelconque ou plusieurs des revendications ci-avant, **caractérisé en ce que** les écrans de protection contre le rayonnement (10) présentent une forme annulaire et sont disposés coaxialement par rapport à l'axe médian longitudinal (13) du moule (6).

7. Four de fusion et de coulée selon l'une quelconque ou plusieurs des revendications ci-avant, **caractérisé en ce que** les écrans de protection contre le rayonnement (10) présentent une forme annulaire et ont le même diamètre intérieur.

8. Four de fusion et de coulée selon l'une quelconque ou plusieurs des revendications ci-avant, **caractérisé en ce que** les écrans de protection contre le rayonnement (10) présentent une forme annulaire et ont des diamètres de différentes dimensions.

9. Four de fusion et de coulée selon l'une quelconque ou plusieurs des revendications ci-avant, **caractérisé en ce que** l'écran inférieur (10) est disposé dans la zone de l'anneau de refroidissement (4) ou fixé sur celui-ci.

10. Four de fusion et de coulée selon l'une quelconque ou plusieurs des revendications ci-avant, **caractérisé en ce que** les écrans de protection contre le rayonnement (10) sont fixés dans un cadre et peuvent être installés à l'intérieur du dispositif de chauffage (15).
